# DEMANDE DE BREVET EUROPEEN

(11) **EP 1 768 176 A2**
(43) Date de publication de la demande: **28.03.2007**
(21) Numéro de dépôt: 06291790.1
(22) Date de dépôt: 13.05.1997
(51) Int. Cl.: H01L 21/762, H01L 21/304

(54) **Procédé de réalisation d'une couche mince de matériau semiconducteur**

(30) Priorité: 15.05.1996 FR 9606086
(62) Demande divisionnaire de: 97401062.1
(71) Demandeur: COMMISSARIAT A L'ENERGIE ATOMIQUE, 75015 Paris (FR)
(72) Inventeur: Aspar, Bernard, 38140 Rives (FR); Bruel, Michel, 38113 Veurey (FR); Poumerol, Thierry, 38410 Saint Martin d'Uriage (FR)
(74) Mandataire: Santarelli

(57) **Abrégé**

Un procédé de réalisation d'une couche mince en matériau semiconducteur comporte une implantation ionique d'une plaquette avec une dose d'ions de gaz rares ou d'hydrogène permettant une fragilisation de la plaquette au niveau d'un plan de référence, insuffisante pour obtenir, et un traitement thermique en vue d'obtenir une séparation de la plaquette en deux parties, de part et d'autre du plan de référence, dont cette couche mince 6.

La fragilisation est insuffisante pour obtenir la séparation au cours du traitement thermique. La séparation de la plaquette en deux parties est conduite par application de forces mécaniques entre les deux parties 6 et 7 de la plaquette, cette plaquette étant, avant cette séparation, mise en contact intime et solidarisée, du côté de la face 2 par laquelle l'implantation a eu lieu, avec un support 8 de manière à assurer entre ce support et cette face une énergie de liaison suffisante pour résister à l'application ultérieure des forces mécaniques.

## Description

La présente invention concerne un procédé de réalisation d'une couche mince de matériau semiconducteur. La couche mince réalisée peut éventuellement être pourvue de composants électroniques.

L'invention permet la réalisation de couches minces de semiconducteur aussi bien monocristallin que polycristallin et même amorphe et par exemple la réalisation de substrats de type Silicium Sur Isolant, la réalisation de couches minces autoportantes de semiconducteur monocristallin. Des circuits électroniques et/ou des microstructures peuvent être réalisés complètement ou en partie dans ces couches ou dans ces substrats.

Il est connu que l'implantation d'ions d'un gaz rare ou d'hydrogène dans un matériau semiconducteur induit la formation de microcavités à une profondeur voisine de la profondeur moyenne de pénétration des ions. Le document FR-A-2 681 472 divulgue un procédé qui utilise cette propriété pour obtenir un film mince de matériau semiconducteur. Ce procédé consiste à soumettre une plaquette du matériau semiconducteur désiré et comportant une face plane aux étapes suivantes :
- une première étape d'implantation par bombardement de la face plane de la plaquette au moyen d'ions créant, dans le volume de la plaquette et à une profondeur voisine de la profondeur de pénétration des ions, une couche de microcavités séparant la plaquette en une région inférieure constituant la masse du substrat et une région supérieure constituant le film mince, les ions étant choisis parmi les ions de gaz rares ou de gaz hydrogène et la température de la plaquette étant maintenue au-dessous de la température à laquelle les ions implantés peuvent s'échapper du semiconducteur par diffusion ;
- une deuxième étape de mise en contact intime de la face plane de la plaquette avec un support constitué au moins d'une couche de matériau rigide. Ce contact intime pouvant être réalisé par exemple à l'aide d'une substance adhésive ou par l'effet d'une préparation préalable des surfaces et éventuellement d'un traitement thermique ou/et électrostatique pour favoriser les liaisons interatomiques entre le support et la plaquette ;
- une troisième étape de traitement thermique de l'ensemble plaquette et support à une température supérieure à la température durant laquelle l'implantation a été effectuée et suffisante pour créer par effet de réarrangement cristallin dans la plaquette et de pression des microcavités une séparation entre le film mince et la masse du substrat. Cette température est par exemple de 500°C pour du silicium.

Cette implantation est apte à créer une couche de microbulles gazeuses. Cette couche de microbulles créée ainsi dans le volume de la plaquette, à une profondeur voisine de la profondeur moyenne de 'pénétration des ions, délimite dans le volume de la plaquette deux régions séparées par cette couche : une région destinée à constituer le film mince et une région formant le reste du substrat.

Suivant les conditions d'implantation, après implantation d'un gaz comme par exemple l'hydrogène, des cavités ou microbulles sont observables ou non en microscopie électronique à transmission. Dans le cas du silicium, on peut avoir des microcavités dont la taille peut varier de quelques nm à quelques centaines de nm. Ainsi, en particulier lorsque la température d'implantation est faible, ces cavités ne sont observables qu'au cours de l'étape de traitement thermique, étape au cours de laquelle on réalise alors une nucléation pour permettre d'aboutir en fin de traitement thermique à la coalescence des microcavités.

Le procédé décrit dans le document FR-A-2 681 472 ne permet pas de réaliser des circuits électroniques dans et à la surface de la face plane de la plaquette après l'étape d'implantation ionique. En effet, la réalisation de tels circuits implique d'effectuer certaines opérations classiques de microélectronique (recuit de diffusion, déposition, etc.) qui nécessitent des étapes de traitement thermique (typiquement de 400°C à 700°C) selon les étapes pour le silicium. Or, à ces températures, il se forme des cloques sur la surface de la face plane de la plaquette implantée. A titre d'exemple, pour une implantation d'ions hydrogène selon une dose de 5.1016 protons/cm2 et de 100 keV d'énergie dans une plaquette de silicium, un traitement thermique réalisé à 500°C pendant 30 min conduit à une dégradation de 50% de la surface de la face plane de la plaquette, cette dégradation résultant de l'apparition de cloques et de leur éclatement. Il n'est alors plus possible d'assurer correctement la mise en contact intime de la face plane de la plaquette avec le support (que l'on appellera applicateur dans la suite de la description) afin de décoller la couche semiconductrice du reste de la plaquette.

Ce phénomène de formation de cloques et de cratères à la surface d'une plaquette de silicium implantée d'ions hydrogène après recuit a été discuté dans l'article "Investigation of the bubble formation mechanism in a-Si:H films by Fourier-transform infrared microspectroscopy" de Y. Mishima et T. Yagishita, paru dans J. Appl.Phys. 64 (8), 15 Octobre 1988, pages 3972-3974.

La présente invention a été conçue pour perfectionner le procédé décrit dans le document FR-A-2 681 472. Elle permet, après une étape d'implantation ionique dans une gamme de doses appropriées et avant l'étape de séparation, de réaliser un traitement thermique de la partie de la plaquette correspondant à la future couche mince, en particulier entre 400°C et 700°C pour le silicium, sans dégrader l'état de surface de la face plane de la plaquette et sans séparation de la couche mince. Ce traitement thermique intermédiaire peut faire partie des opérations d'élaboration de composants électroniques ou être imposé pour d'autres raisons.

L'invention s'applique également au cas où l'épaisseur de la couche mince est suffisante pour lui conférer une bonne tenue mécanique, auquel cas il n'est pas nécessaire d'utiliser un applicateur pour obtenir la séparation de la couche mince du reste de la plaquette, mais où l'on désire malgré tout éviter des défauts de surface à la face plane.

L'invention a donc pour objet un procédé de réalisation d'une couche mince de matériau semiconducteur à partir d'une plaquette dudit matériau comportant une face plane, comprenant une étape d'implantation ionique consistant à bombarder ladite face plane par des ions choisis parmi les ions de gaz rares ou d'hydrogène, selon une température déterminée et une dose déterminée pour créer, dans un plan dit plan de référence et situé à une profondeur voisine de la profondeur moyenne de pénétration des ions, des microcavités, le procédé comprenant également une étape postérieure de traitement thermique à une température suffisante en vue d'obtenir une séparation de la plaquette en deux parties, de part et d'autre dudit plan de référence, la partie située du côté de la face plane constituant la couche mince, caractérisé en ce que :
- l'étape d'implantation ionique est conduite avec une dose d'ions comprise entre une dose minimum et une dose maximum, la dose minimum étant celle à partir de laquelle il y aura une création suffisante de microcavités pour obtenir la fragilisation de la plaquette suivant le plan de référence, la dose maximum, ou dose critique, étant celle au-dessus de laquelle, pendant l'étape de traitement thermique, il y a séparation de la plaquette,
- une étape de séparation de la plaquette en deux parties, de part et d'autre du plan de référence, est prévue après ou pendant l'étape de traitement thermique, cette étape de séparation comportant l'application de forces mécaniques entre les deux parties de la plaquette.

Ces forces mécaniques peuvent être des forces de traction, de cisaillement et de flexion appliquées seules ou en combinaison.

On entend dans la demande par microcavités, des cavités pouvant se présenter sous forme quelconque ; par exemple, les cavités peuvent être de forme aplatie, c'est-à-dire de faible hauteur (quelques distances interatomiques) ou de forme sensiblement sphérique ou de toute autre forme différente. Ces cavités peuvent contenir une phase gazeuse libre et/ou des atomes de gaz issus des ions implantés fixés sur des atomes du matériau formant les parois des cavités. Ces cavités sont généralement appelées en terminologie anglo-saxonne "platelets", "microblisters" ou même "bubbles".

Le traitement thermique réalisé en vue de l'obtention de la séparation de la couche mince du reste de la plaquette, permet d'amener les microcavités dans un état stable. En effet, sous l'effet de la température, les microcavités coalescent pour atteindre un état définitif. La température est donc choisie de façon à obtenir cet état.

Selon le document FR-A-2 681 472, les doses implantées sont telles que l'on obtient, sous l'effet du traitement thermique, une couche de microcavités qui permet d'obtenir directement la séparation.

Selon la présente invention, les doses implantées sont insuffisantes pour obtenir au cours du traitement thermique une séparation, les doses implantées permettent seulement une fragilisation de la plaquette au niveau du plan de référence, la séparation nécessite une étape supplémentaire par application de forces mécaniques. En outre, la dose critique telle que définie dans l'invention est inférieure à la dose à laquelle aux cours des étapes d'implantation ionique et de traitement thermique, il y a formation de cloques sur la face plane de la plaquette. Le problème de cloques ne se pose donc pas dans l'invention.

Le procédé selon l'invention peut comprendre, entre l'étape de traitement thermique et l'étape de séparation, une étape consistant à réaliser au moins tout ou partie d'un composant électronique dans la partie de la plaquette devant constituer la couche mince.

Si la réalisation de ce composant électronique nécessite des phases de traitement thermique, celles-ci sont de préférence menées à une température inférieure à celle du traitement thermique.

En cas de besoin, juste avant l'étape de séparation, il est prévu une étape supplémentaire consistant à mettre en contact intime et à solidariser ladite plaquette, du côté de ladite face plane, avec un support par l'intermédiaire duquel les forces mécaniques telles que des forces de traction et/ou de cisaillement seront appliquées.

Ce support peut être un support souple, par exemple une feuille de Kapton®. Il peut être un support rigide comme une plaquette de silicium oxydé.

L'invention sera mieux comprise et d'autres avantages et particularités apparaîtront à la lecture de la description qui va suivre, donnée à titre d'exemple non limitatif, parmi lesquels :
- la figure 1 représente, de façon schématique, une plaquette de matériau semiconducteur dont l'une de ses faces est soumise à un bombardement d'ions en application du procédé selon la présente invention,
- la figure 2 représente, de façon schématique, la plaquette précédente à l'issue de l'étape de traitement thermique destinée à faire coalescer les microcavités, selon la présente invention,
- la figure 3 représente, de façon schématique, la plaquette précédente après formation de composants électroniques dans la partie correspondant à la couche mince désirée,
- la figure 4 représente, de façon schématique, l'étape de séparation de la plaquette précédente en deux parties, conformément à la présente invention.

Un point important de la présente invention réside dans l'implantation d'ions d'hydrogène ou de gaz rare, selon une dose inférieure ou égale à la dose au-dessus de laquelle il y aurait séparation au cours du traitement thermique. La dose utilisée est telle qu'elle permet une fragilisation du matériau à une profondeur Rp correspondant au parcours moyen des ions dans le matériau, mais la plaquette reste suffisamment résistante mécaniquement pour supporter toutes les étapes de traitement thermique nécessaires à la réalisation de circuits électroniques. Autrement dit, la plaquette implantée présente, dans la zone de microcavités, des ponts solides reliant la partie de la plaquette destinée à constituer la couche mince à la partie restante de la plaquette.

La description va maintenant porter sur la réalisation d'une couche mince en matériau semiconducteur à partir d'un substrat épais présentant une face plane. Le substrat de départ peut être ou non recouvert sur cette face plane d'une ou de plusieurs couches de matériaux, comme par exemple des matériaux encapsulants tels qu'un diélectrique.

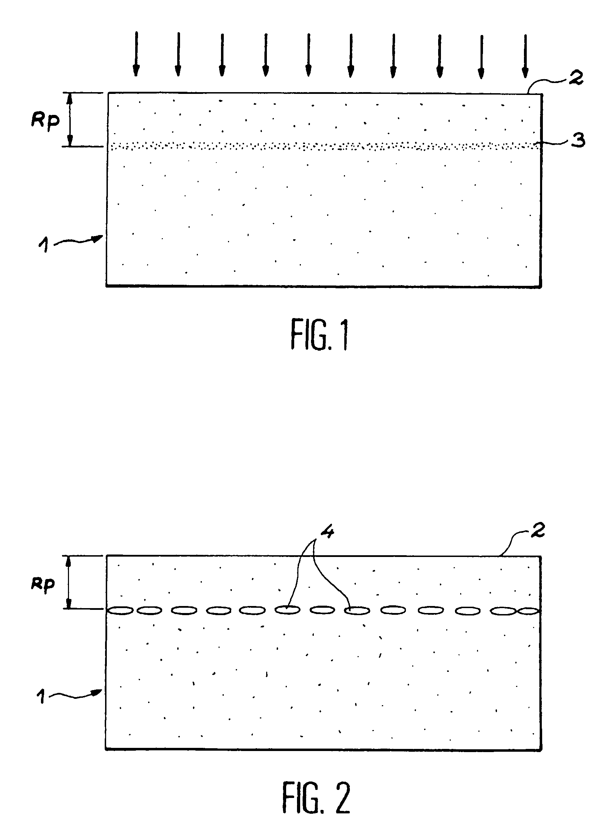

La figure 1 illustre l'étape d'implantation ionique d'une plaquette 1 en matériau semiconducteur. La face plane 2 de la plaquette reçoit le bombardement ionique qui est figuré par des flèches. Dans le cas où la face plane 2 de la plaquette est recouverte d'un ou de plusieurs matériaux non semiconducteurs, l'énergie des ions est choisie suffisante pour qu'ils pénètrent dans la masse de matériau semiconducteur.

Le cas échéant, l'épaisseur de matériau semiconducteur implanté doit être telle que l'on puisse réaliser tout ou partie de composants électroniques et/ou des microstructures dans la couche mince. A titre d'exemple, la pénétration moyenne des ions hydrogène est de 2 µm à 200 keV dans du silicium.

L'implantation ionique de ces types d'ions dans le substrat semiconducteur crée en profondeur, au voisinage de la profondeur correspondant au parcours moyen Rp des ions suivant une perpendiculaire à la face plane, une zone 3 à forte concentration en atomes donnant naissance à des microcavités. Par exemple, la concentration maximum en hydrogène est de 10²¹ H⁺/cm³ pour une dose d'implantation de 2.10¹⁶ H⁺/cm² à 100 keV. Cette étape d'implantation ionique doit être réalisée à une température telle que les ions de gaz implantés ne diffusent pas au fur et à mesure (pendant l'étape d'implantation) à longue distance. Ceci perturberait ou annihilerait la formation de microcavités. Par exemple, dans le cas d'une implantation d'ions d'hydrogène dans du silicium on réalisera l'implantation ionique à une température inférieure à 350°C.

La dose d'implantation (nombre d'ions par unité de surface reçu pendant la durée de l'implantation) est choisie de sorte que la dose soit inférieure ou égale à une dose, dite dose critique, telle que, au-dessus de cette dose critique, pendant l'étape subséquente de traitement thermique, il y a séparation de la couche mince du reste de la plaquette. Dans le cas d'une implantation d'ions hydrogène, cette dose critique est de l'ordre de 4.10¹⁶ H⁺/cm² pour une énergie de 160 keV.

La dose d'implantation est également choisie supérieure à une dose minimum à partir de laquelle, lors de l'étape de traitement thermique subséquente, la formation de microcavités et l'interaction entre celles-ci est suffisante, c'est-à-dire qu'elle permet de fragiliser le matériau implanté dans la zone de microcavités 3. Cela veut dire qu'il existe encore des ponts solides de matériau semiconducteur situé entre les microcavités. Dans le cas d'une implantation d'ions de gaz hydrogène dans un substrat de silicium, cette dose minimum est de l'ordre de 1.10¹⁶/cm² à une énergie de 100 keV.

L'étape suivante du procédé selon l'invention consiste en un traitement thermique de la plaquette à une température suffisante pour permettre une coalescence des microcavités suivant le plan de référence. Dans le cas d'une implantation, à une température inférieure à 350°C, d'ions de gaz hydrogène dans un substrat de silicium et une dose de 3.10¹⁶ H⁺/cm2 à une énergie de 100 keV, après un traitement thermique de trente minutes à 550°C, on observe par microscopie électronique à transmission en coupe, des cavités de hauteur égale à quelques fractions de nanomètres et d'extension suivant le plan de référence de plusieurs nanomètres voire plusieurs dizaines de nanomètres. Ce traitement thermique permet à la fois la précipitation et la stabilisation des atomes de gaz implantés sous forme de microcavités.

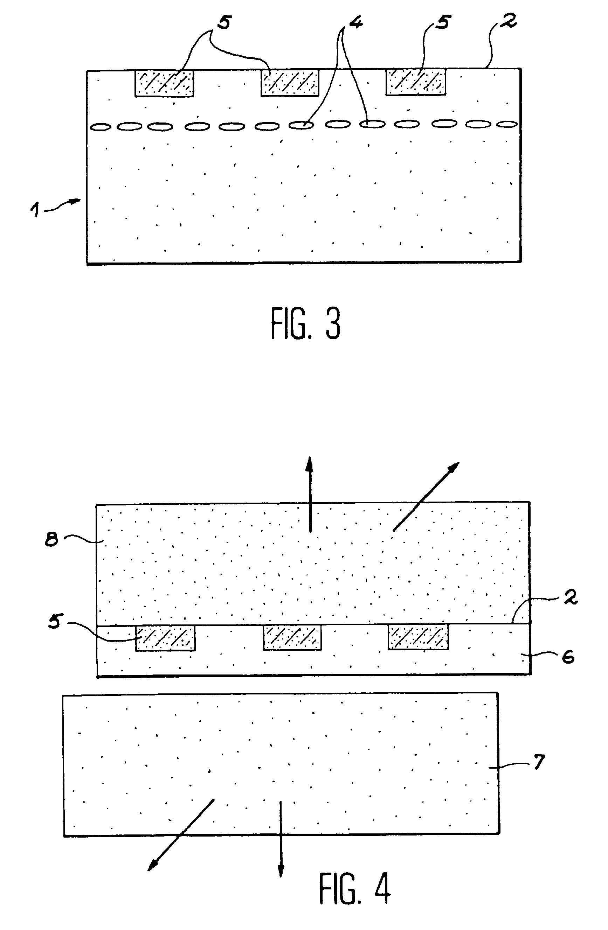

Les microcavités 4 (voir la figure 2) occupent, suivant le plan de référence, une surface sensiblement égale à la surface implantée. Les cavités 4 ne se situent pas exactement dans le même plan. Elles se trouvent dans des plans parallèles au plan de référence à quelques nanomètres ou dizaines de nanomètres de ce plan de référence. De ce fait, la partie supérieure du substrat situé entre le plan de référence et la face plane 2 n'est pas totalement séparée de la masse du substrat, la masse du substrat étant définie comme le reste du substrat compris entre le plan de référence et les faces du substrat autres que la face plane. Les liaisons restantes sont suffisamment fortes pour supporter des étapes de manipulation et de recuit dues aux étapes technologiques dans la réalisation de circuits intégrés. Cependant, la liaison entre la partie supérieure et la masse du substrat est très affaiblie puisque cette liaison n'est réalisée que par l'intermédiaire de ponts de matériau semiconducteur situés entre les cavités.

On peut ensuite réaliser sur la face plane 2 (à la surface et sous la surface) tout ou partie des composants électroniques, des circuits et des microstructures.

L'énergie d'implantation ionique des ions d'hydrogène ou de gaz rare de la première étape a été choisie de telle façon que la profondeur de la zone de microcavités soit suffisante pour qu'elle ne soit pas perturbée par la réalisation de composants, de circuits électroniques et/ou de microstructures durant cette étape. En outre, l'ensemble des opérations de recuit thermique que nécessite l'élaboration de composants, de circuits électroniques ou de microstructures, est choisi de façon à minimiser une éventuelle diffusion des ions implantés. Par exemple, dans le cas d'une plaquette de silicium monocristallin, on limitera préférentiellement la température maximum des diverses phases du procédé à 900°C.

La figure 3 illustre le cas où l'on a élaboré plusieurs composants électroniques, référencés 5, sur la face plane 2 et dans la partie de la plaquette destinée à constituer la couche mince.

L'étape de séparation vient ensuite. Elle consiste à appliquer des forces mécaniques, par exemple de traction, séparatrices entre les parties de la plaquette ou substrat situées de part et d'autre du plan de référence de façon à fracturer les ponts solides subsistants. Cette opération permet d'obtenir la couche mince de matériau semiconducteur, équipée de composants électroniques dans le cas décrit. La figure 4 illustre cette étape de séparation au cours de laquelle la couche mince 6 est séparée de la 'masse restante 7 du substrat par l'action de forces exerçant leurs actions en sens contraires et figurées par des flèches.

L'expérience montre que l'effort de traction nécessaire pour séparer la partie supérieure de la masse du substrat est faible en particulier lorsque l'on exerce un effort de cisaillement entre la partie supérieure et la masse du substrat, c'est-à-dire quand les forces exercées présentent une composante suivant le plan de référence. Ceci s'explique simplement par le fait que l'effort de cisaillement favorise la propagation des fractures et des cavités dans le plan de référence.

La partie supérieure du substrat étant par nature mince, l'effort de traction et/ou de cisaillement ne peut pas, dans bien des cas, être appliqué commodément directement sur celle-ci. Il est alors préférable, avant l'étape de séparation, de rendre la plaquette solidaire, par sa face plane 2, d'un support ou applicateur par l'intermédiaire duquel on appliquera les forces mécaniques à la partie supérieure de la plaquette. Cet applicateur est représenté sous la référence 8 à la figure 4.

L'applicateur peut être un support rigide ou souple. On entend ici par solidarisation de l'applicateur sur la plaquette toute opération de collage ou de préparation des surfaces et de mise en contact, permettant d'assurer une énergie de liaison suffisante entre l'applicateur et la face plane de la plaquette pour résister à l'opération de traction et/ou de cisaillement et/ou de flexion de l'étape de séparation.

L'applicateur peut être par exemple une feuille de matériau plastique tel que du Kapton® que l'on a rendu adhérent à la face plane du substrat. Dans cet exemple, après application du procédé selon l'invention, on obtient une couche mince de semiconducteur monocristallin sur feuille de Kapton®.

Afin de transmettre correctement les efforts à l'ensemble de la couche mince supérieure, les circuits réalisés dans et à la surface de la couche supérieure peuvent avoir été recouverts d'une couche de protection éventuellement planarisante au cours de l'étape d'élaboration des composants électroniques. L'applicateur est alors solidarisé de la couche mince supérieure de la plaquette par l'intermédiaire de cette couche de protection.

L'applicateur peut être aussi un support rigide, par exemple une plaquette de silicium dont la surface peut être recouverte d'une couche diélectrique. On effectue par exemple un traitement physico-chimique approprié de la face plane de la plaquette et/ou de la surface de l'applicateur (portant ou non une couche diélectrique) pour que la mise en contact associée à un éventuel traitement thermique solidarise la face plane de la plaquette et l'applicateur.

Dans le cas cité à titre d'exemple où l'applicateur est une plaquette de silicium portant à sa surface une couche d'oxyde et où le substrat semiconducteur est une plaquette de silicium monocristallin, après application du procédé selon l'invention, on obtient une plaquette de silicium sur isolant où la couche de silicium superficielle est la couche fine fournie par la partie supérieure du substrat.

En outre, après séparation de la couche mince du reste de la plaquette, la face libre de cette couche peut permettre le report d'un substrat supplémentaire pouvant être équipé de composants électroniques réalisés complètement ou partiellement sur le substrat. Un tel empilement permet un assemblage "trois dimensions" de circuits électroniques, le raidisseur pouvant ou non comporter lui-même des composants électroniques.

## Revendications

1. Procédé de réalisation d'une couche mince de matériau semiconducteur (6) à partir d'une plaquette (1) dudit matériau comportant une face plane (2), comprenant une étape d'implantation ionique consistant à bombarder ladite face plane (2) par des ions choisis parmi les ions de gaz rares ou d'hydrogène, puis une étape postérieure de traitement thermique en vue d'obtenir une séparation de la plaquette en deux parties, de part et d'autre d'un plan de référence, la partie située du côté de la face plane constituant la couche mince (6),
**caractérisé en ce que** :
- l'étape d'implantation ionique est conduite avec une dose d'ions permettant, au niveau du plan de référence, une fragilisation de la plaquette qui est insuffisante pour obtenir la séparation au cours de l'étape de traitement thermique,
- une étape de séparation de la plaquette en deux parties, de part et d'autre du plan de référence, est conduite par application de forces mécaniques entre les deux parties de la plaquette (1),
- une étape supplémentaire consiste, avant l'étape de séparation, à mettre en contact intime et à solidariser ladite plaquette (1), du côté de ladite face plane (2), avec un support (8) de manière à assurer entre le support et la face plane une énergie de liaison suffisante pour résister à l'application ultérieure des forces mécaniques.

2. Procédé selon la revendication 1, **caractérisé en ce qu'**il comprend, entre l'étape de traitement thermique et l'étape de séparation, une étape consistant à réaliser au moins une partie d'un composant électronique (5) dans la partie de la plaquette (1) devant constituer la couche mince (6).

3. Procédé selon la revendication 2, **caractérisé en ce que**, la réalisation dudit composant électronique (5) nécessitant des phases de traitement thermique, celles-ci sont menées à une température inférieure à celle de l'étape de traitement thermique.

4. Procédé selon la revendication 1, **caractérisé en ce que** la solidarisation est une opération de collage, ou de préparation des surfaces et de mise en contact.

5. Procédé selon la revendication 1, **caractérisé en ce que** ledit support (8) est un support souple.

6. Procédé selon la revendication 5, **caractérisé en ce que** ledit support souple est une feuille de Kapton ®.

7. Procédé selon la revendication 1, **caractérisé en ce que** ledit support (8) est un support rigide.

8. Procédé selon la revendication 7, **caractérisé en ce que** ledit support rigide est une plaquette de silicium.

9. Procédé selon la revendication 8, **caractérisé en ce que** ladite plaquette de silicium porte à sa surface une couche d'oxyde.

10. Procédé selon la revendication 8, **caractérisé en ce que** la plaquette de silicium est recouverte d'une couche diélectrique.

11. Procédé selon l'une quelconque des revendications 1 à 10, **caractérisé en ce que** ladite plaquette de matériau semiconducteur (1) est en silicium.

12. Procédé selon la revendication 11, **caractérisé en ce que** ladite plaquette de matériau semiconducteur (1) est en silicium monocristallin.

13. Procédé selon l'une quelconque des revendications 1 à 12, **caractérisé en ce que** l'étape d'implantation est effectuée avec des ions hydrogène.

14. Procédé selon la revendication 13, **caractérisé en ce que** la dose minimum est de 1.10¹⁶/cm² à une énergie de 100 keV et la dose critique est de 4.10¹⁶/cm² à une énergie de 160 keV.

15. Procédé selon la revendication 13 ou la revendication 14, **caractérisé en ce que** l'implantation est réalisée à une température inférieure à 350°C.

16. Procédé selon l'une quelconque des revendications précédentes, **caractérisé en ce que** ladite plaquette de matériau semiconducteur (1) est recouverte, du côté de la face plane (2), d'une couche de matériau non semiconducteur.

17. Procédé selon la revendication 16, **caractérisé en ce que** le matériau non semiconducteur est un matériau diélectrique.

18. Procédé selon l'une quelconque des revendications précédentes, **caractérisé en ce que** les forces mécaniques appliquées lors de l'étape de séparation sont des forces de traction et/ou de cisaillement et/ou de flexion.

19. Procédé selon la revendication 18, **caractérisé en ce que** les forces exercées comportent une composante suivant le plan de référence.
